# EUROPEAN PATENT APPLICATION

(11) **EP 4 718 722 A1**
(43) Date of publication of application: **01.04.2026**
(21) Application number: 25198858.0
(22) Date of filing: 28.08.2025
(51) Int. Cl.: H03K 5/135, H03K 19/17796, G11C 29/36, G11C 29/12

(54) **DATA TRANSFER OVER AN INTERCONNECT BETWEEN DIES OF A THREE-DIMENSIONAL DIE STACK**

(30) Priority: 30.09.2024 US 202418902009
(71) Applicant: INTEL Corporation, Santa Clara, CA 95054 (US)
(72) Inventor: CHANDRAKANTHAN, Santhosh Kumar, 560068 Bangalore (IN)
(74) Representative: HGF

(57) **Abstract**

An example integrated circuit (100) disclosed herein includes a first die (105) including first microbumps (135) associated with a source-synchronous data interface of a three-dimensional, 3D, die stack, a first one of the first microbumps in circuit with a clock output (125) of the first die, a second one of the first microbumps in circuit with a data output (130) of the first die, the clock output and the data output associated with a transmitter side of the source-synchronous data interface. The example integrated circuit also includes a second die (110) including second microbumps (150) associated with the source-synchronous data interface of the 3D die stack, a first one of the second microbumps in circuit with a clock input of the second die, a second one of the second microbumps in circuit with a data input of the second die, the clock input and the data input associated with a receiver side of the source-synchronous data interface.

## Description

### BACKGROUND

Hybrid bond interconnect (HBI) is a type of interconnect technology for stacking dies of an integrated circuit into a three-dimensional (3D) die stack. In HBI, the dies of the 3D die stack include microbumps that are bonded together to form signal connections between dies. HBI also enables dies associated with different process technologies to be bonded together into the 3D die stack of the integrated circuit.

### BRIEF DESCRIPTION OF THE DRAWINGS

FIG. 1 is a block diagram of an example three-dimensional (3D) die stack including two example dies that implement one or more example source-synchronous data interfaces in accordance with teachings of this disclosure.
FIG. 2 is a simplified functional diagram of one of the source-synchronous data interfaces implemented by the dies of the 3D die stack if FIG. 1.
FIG. 3 is a circuit diagram of the 3D die stack of FIG. 1 in which the example dies implement two example source-synchronous data interfaces that support single data rate operation.
FIG. 4 includes example waveforms that illustrate example operation of one of the single data rate source-synchronous data interfaces of FIG. 3.
FIG. 5 is a circuit diagram of the 3D die stack of FIG. 1 in which the example dies implement two example source-synchronous data interfaces that support double data rate operation.
FIG. 6 includes example waveforms that illustrate example operation of one of the double data rate source-synchronous data interfaces of FIG. 5.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

Hybrid Bond Interconnect (HBI) is an interconnect technology for bonding dies of an integrated circuit or other device into a three-dimensional (3D) die stack. In HBI, the dies to be included in a 3D die stack include microbumps that that are bonded together to form signal connections between dies. For example, microbumps can be any protrusions, pads, areas, etc., of conductive material, such as one or more types of metal, that come into contact when two dies are pressed together and, in some examples, subject to an appropriate amount of heat (e.g., during annealing). In some examples, a dielectric material is employed between the microbumps to bond the dies together into the 3D die stack (e.g., during annealing).

HBI also permits dies associated with different process technologies to be bonded together into a 3D die stack of an integrated circuit or other device. For example, two dies associated with different process technologies can be bonded together if the microbumps of two different dies are dimensioned such that they come into contact and form the appropriate signal connections when the two dies are pressed and bonded together into the 3D die stack. The different process technologies associated with two different dies of a 3D die stack can be different semiconductor technologies (e.g., with one die corresponding to a silicon semiconductor and the other die corresponding to a gallium arsenide (GaAs) semiconductor), different metal and/or dielectric thicknesses, different heat and/or pressure characteristics, etc.

3D die stacks enable data intensive applications, such as artificial intelligence (AI) applications, in a compact package. For example, a 3D die stack for an AI application may include one or more processor circuits, such as one or more central processing units (CPUs), one or more graphics processing units (GPUs) etc., in one of the dies of the die stack, and may include memory and/or cache circuitry in the other die of the die stack. To achieve acceptable performance, such data intensive applications, such as AI, may expect a high speed, low latency communications between the processor circuit(s) (e.g., CPU(s), GPU(s), etc.) and the memory/cache circuitry. However, some communication techniques for transferring data from one die to another may have difficulty providing such high speed, low latency communications, especially for data transfer among dies associated with different process technologies.

For example, synchronous data transfer is one technique for transferring data from a transmitter (or source) die to a receiver (or destination) die. In synchronous data transfer, a reference clock is used to synchronize data transmission by the transmitter die with data reception by the receiver die. However, in synchronous data transfer, the reference clock source may be provided separately from the data to be transmitted from the transmitter die to the receiver die. For example, the reference clock may be provided by a clock source separate from the transmitter die and/or the receiver die, and/or the reference clock may be provided by a communication path separate from (e.g., located on a different part of the dies) the data connections between the transmitter die and the receiver die. Because the reference clock may come from a different source or take a different communication path than the data, synchronous data transfer between the two dies may exhibit timing drift and/or latency between the reference clock and data connection(s). Such timing drift and/or latency may become even more pronounced if the transmitter die and the receiver die are associated with different process technologies, and/or if there are many data connections spread over the die area. Thus, to account for timing drift and/or latency, synchronous data transfer techniques may employ setup and hold periods during which the receiver die waits before sampling the data connections using the reference clock, which increases the latency and reduces the data throughput able to be achieved by synchronous data transfer.

In contrast, example techniques disclosed herein to transfer data over 3D die stack interconnects reduce or eliminate the timing drift and/or latency between the clock and data connections and, thus, reduce or eliminate the need for setup and hold periods for data communications. As a result, example techniques disclosed herein can exhibit decreased latency and increased data throughput relative to synchronous data transfer. Example techniques disclosed herein achieve such improvements in the operation of the circuitry by employing source-synchronous data transfer and, in some examples, co-locating placement of the clock connection among the data connections between the dies of the 3D die stack.

In source-synchronous data transfer, the transmitter die of the 3D data stack is responsible for generating and synchronizing the clock with the data being transmitted over the die interconnect. As such, relative to synchronous data transfer, there is less drift and/or latency between the clock and the data signals received over the die interconnect by the receiver die of the 3D data stack. Furthermore, in some examples disclosed herein, the clock signal is provided over a microbump connection that is interior to the microbump connections providing the data signals over the interconnect. For example, the microbump connection for the clock signal may be centrally located among a group of other microbump connections providing the data signals over the interconnect. Using such a co-location arrangement, the clock signal and data signals are subjected to the same or similar propagation delays when being communicated between the dies of the 3D die stack, even if those dies are associated with different process technologies. As such, there may be little to no relative timing latency, shift, delay, etc., between the clock and data signals, thereby enabling the receiver die to sample the data signals based on the clock signal without the use of setup and hold times, which can result in improved latency and throughput relative to synchronous data transfer.

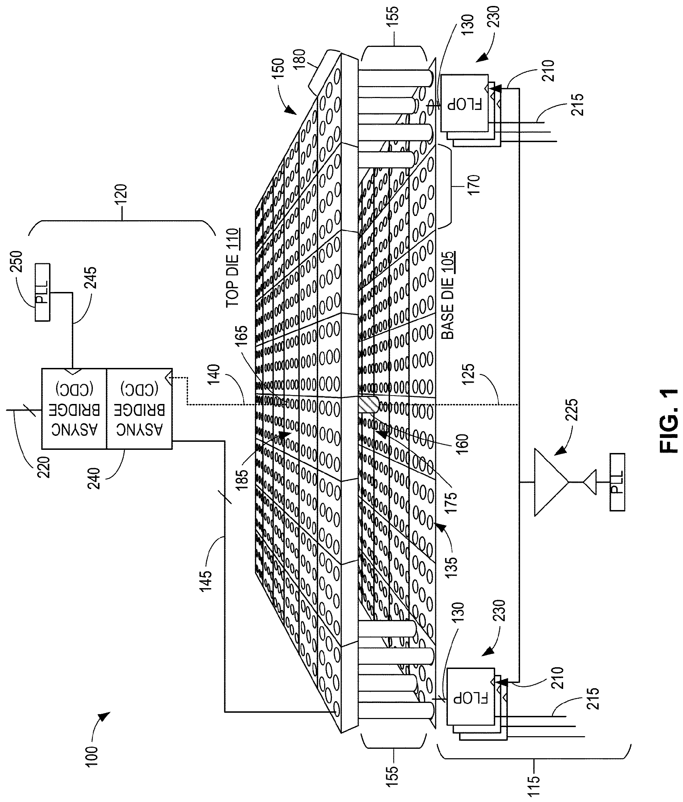

Turning to the figures, an example 3D die stack 100 including two example dies 105 and 110 that implement one or more example source-synchronous data interfaces in accordance with teachings of this disclosure is illustrated in FIG. 1. The 3D die stack 100 can be included in an integrated circuit or any other device, chip, apparatus, etc., such as a system-on-a-chip (SoC) device, an application specific integrated circuit (ASIC), etc. In the illustrated example, the 3D die stack includes the base die 105, which includes example transmitter circuitry 115 to implement the transmitter-side of a source-synchronous data interface of the 3D die stack 100. In the illustrated example, the 3D die stack also includes the top die 110, which includes example receiver circuitry 120 to implement the receiver-side of the source-synchronous data interface of the 3D die stack 100.

In the example of FIG. 1, the transmitter circuitry 115 of the base die 105 includes an example clock output 125 and one or more example data outputs 130 that are coupled respectively to example microbumps 135 of the base die 105. The clock output 125 provides an example clock signal, and the data output(s) 130 provide example data signals that are source-synchronized by the transmitter circuitry 115. Likewise, the receiver circuitry 120 of the top die 110 includes an example clock input 140 and one or more example data inputs 145 that are coupled respectively to example microbumps 150 of the top die 110. The microbumps 135 and 150 can be implemented by protrusions, pads, areas, etc., of conductive material, such as one or more types of metal, that come into contact and bond together to implement an example interconnect 155 when the two dies 105 and 110 are pressed together and, in some examples, subject to an appropriate amount of heat. In some examples, a dielectric material is employed between the microbumps 135 and 150 to bond the dies 105 and 110 together into the 3D die stack 100.

In some examples, two or more elements of FIG. 1 are coupled to one another if they are in circuit with one another, in communication with one another, etc., directly or indirectly via one or more intermediate elements.

In the illustrated example, corresponding ones of the microbumps 135 of the base die 105 and the microbumps of the top die 110 are bonded together to implement the clock and data connections for the source-synchronous data interface of the die stack 100. For example, the clock output 125 is coupled to an example microbump 160 of the microbumps 135 of the base die 105, and the clock input 140 is coupled to an example microbump 165 included in the microbumps 150 of the top die 110. In this example, the microbumps 135 of the base die 105 and the microbumps 150 of the top die 110 are arranged such that the microbump 160 coupled to the clock output 125 and the microbump 165 of the clock input 140 come into contact and are bonded together when the microbumps 135 and 150 are bonded together. Likewise, remaining ones of the microbumps 150 that are coupled to the data outputs 130 of the base die 105 come into contact and are bonded to corresponding ones of the microbumps 150 that are coupled to the data inputs 145 of the top die 110 such that the data outputs 130 are coupled to their counterpart data inputs 145.

In some examples, such as in the example of FIG. 1, the microbumps 135 of the base die 105 are arranged such that a set of the microbumps 135 that are coupled to corresponding data outputs 130 form a perimeter of an area of the base die 105 (e.g., corresponding to the set of the microbumps 135 along the edges of the group of microbumps 135). Furthermore, in such examples, the microbump 160 coupled to the clock output 125 is an interior microbump relative to the perimeter of the microbumps 135. For example, the microbump 160 coupled to the clock output 125 may be located centrally (e.g., at or near the center) in the group of microbumps 135. With such an arrangement, the clock signal provided by the clock output 125 is co-located with the data signals provided by the data outputs 130, thereby resulting in little to no propagation delay between the clock signal and the data signal(s).

In some examples, such as in the example of FIG. 1, the microbumps 135 of the base die 105 include example cells 170 of microbumps arranged in a grid. In some such examples, an example cell 175 of the cells 170 includes the microbump 160 that is coupled to the clock output 125 of the base die 105. Also, in some examples, in the cell 175, the microbump 160 that is coupled to the clock output 125 may be surrounded (fully or at least partially) by a group of the microbumps 135 coupled to respective data outputs 130 of the base die 105. Furthermore, in some examples, the cell 175 including the microbump 160 that is coupled to the clock output 125 may be surrounded (fully or at least partially) by other cells 170 including groups of the microbumps 135 coupled to respective data outputs 130 of the base die 105. For example, the cell 175 including the microbump 160 that is coupled to the clock output 125 may be located centrally (e.g., at or near the center) in the cells 170 of the microbumps 135 of the base die 105. With such an arrangement, the clock signal provided by the clock output 125 is co-located with the data signals provided by the data outputs 130, thereby resulting in little to no propagation delay between the clock and data signals.

Similarly, in some examples, such as in the example of FIG. 1, the microbumps 150 of the top die 110 are arranged such that a set of the microbumps 150 that are coupled to corresponding data inputs 145 form a perimeter of an area of the top die 110 (e.g., corresponding to the set of the microbumps 150 along the edges of the group of microbumps 150). Furthermore, in such examples, the microbump 165 coupled to the clock input 140 is an interior microbump relative to the perimeter of the microbumps 150. For example, the microbump 165 may be located centrally (e.g., at or near the center) in the group of microbumps 150.

In some examples, such as in the example of FIG. 1, the microbumps 150 of the top die 110 include example cells 180 of microbumps arranged in a grid. In some such examples, an example cell 185 of the cells 180 includes the microbump 165 that is coupled to the clock input 140 of the top die 110. Also, in some examples, in the cell 185, the microbump 165 that is coupled to the clock input 140 may be surrounded (fully or at least partially) by a group of the microbumps 150 coupled to respective data inputs 145 of the top die 105. Furthermore, in some examples, the cell 185 including the microbump 165 that is coupled to the clock input 140 may be surrounded (fully or at least partially) by other cells 180 including groups of the microbumps 150 coupled to respective data inputs 145 of the top die 110. For example, the cell 185 including the microbump 165 that is coupled to the clock input 140 may be located centrally (e.g., at or near the center) in the cells 180 of the microbumps 150 of the top die 110.

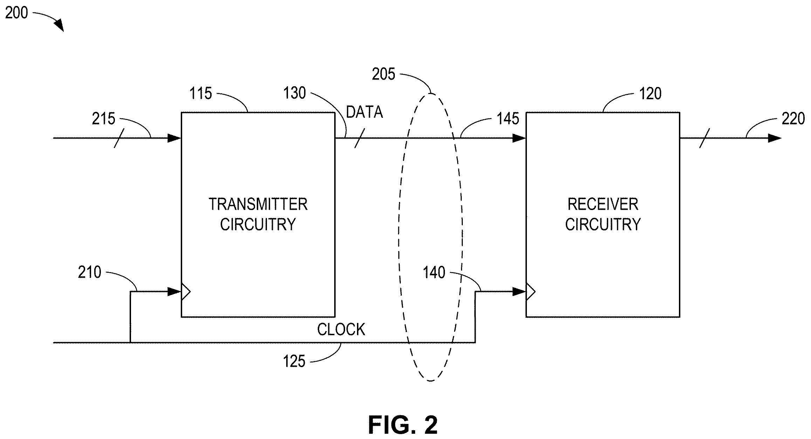

As mentioned above, in the illustrated example of FIG. 1, the transmitter circuitry 115 of the base die 105 implements the transmitter-side and the receiver circuitry 120 of the top die 110 implements the receiver-side of the illustrated source-synchronous data interface of the 3D die stack 100. A simplified functional diagram 200 of an example source-synchronous data interface 205 implemented by the transmitter circuitry 115 of the base die 105 and the receiver circuitry 120 of the top die 110 is illustrated in FIG. 2. In the functional diagram 200 of FIG. 2, the transmitter circuitry 115 has an example clock input 210 to accept a clock signal and one or more example data inputs 215 to accept one or more input data signals. The inputs data signal(s) can come from any data source or combination of data sources, such as, but not limited to, one or more memories or memory circuits, one or more caches or cache circuits, one or more network interfaces or network interface circuits/cards, etc. The transmitter circuitry 115 also includes the one or more example data outputs 130 to provide one or more output data signals for transmission to the top die 110, and also includes the example clock output 125 to output the clock signal. As shown in the illustrated example, the transmitter circuitry 115 uses the clock signal at the clock input 210 to sample the input data signal(s) at the data input(s) 215 to produce output data signal(s) at the data output(s) 130 that are synchronized with the clock signal at the clock output 125.

In the functional diagram 200 of FIG. 2, the receiver circuitry 120 includes the example clock input 140 to accept the clock signal from the clock output 125 of the transmitter circuitry 115. The receiver circuitry 120 of the illustrated example also includes the one or more example data inputs 145 to accept the data signal(s) from the data output(s) 130 of the transmitter circuitry 115. The receiver circuitry 120 of the illustrated example further has one or more example data outputs 220 to provide one or more output data signals. As shown in illustrated example, because the clock and data signals are source-synchronous, the receiver circuitry 120 is able to use the clock signal at the clock input 140 to sample the data signal(s) at the data input(s) 145 to produce the output data signal(s) at the data output(s) 220 without the use of setup and hold times, or other clock synchronization operations. The output data signal(s) can be provided to any data consumer circuitry, such as, but not limited to, one or more CPUs, one or more GPUs, one or more hardware accelerators, one or more processor cores, etc.

Returning to the example of FIG. 1, and with reference to the example of FIG. 2, the transmitter circuitry 115 of the base die 105 includes an example clock distribution circuit 225 that generates the clock signal for the source-synchronous data interface of the 3D die stack 100. As such, the clock distribution circuit 225 includes or is coupled to the clock output 125 of the base die 105 to provide the clock signal of the source-synchronous data interface to the top die 110. The clock distribution circuit 225 of the illustrated example includes phase locked loop (PLL) circuitry and one or more buffer circuits to generate and distribute the clock signal to the clock output 125. However, any clock generation and/or distribution circuitry can be used to implement the clock distribution circuit 225.

The transmitter circuitry 115 of the base die 105 also includes example flip-flop (FF) circuits 230 that are coupled to the clock input 210 and the input data input(s) 215 of the transmitter circuitry 115. The flip-flop circuits 230 are also coupled to the data output(s) 130 of the base die 105. In the illustrated example, the flip-flop circuit(s) 230 sample the data signal(s) at the data input(s) 215 based on the clock signal at the clock input 210 to produce the output data signal(s) at the data output(s) 130. As described above, the inputs data signal(s) applied to the data input(s) 215 can come from any data source or combination of data sources, such as, but not limited to, one or more memories or memory circuits, caches or cache circuits, network interfaces or network interface circuits/cards, etc., in the base die 105 or another die of the die stack 100. As shown in the example of FIG. 1, the clock input 210 is coupled to the clock output 125 of the clock distribution circuit 225. As such, the output data signal(s) produced at the data output(s) 130 of the flip-flop circuits 230 are synchronized with the clock signal generated at the clock output 125, thereby achieving the synchronized clock and data signals of the source-synchronous data interface. The flip-flop circuits 230 of the illustrated example can be implemented by any number(s) and/or type(s) of flip-flip circuits, such as, but not limited to, D flip-flips, J-K flip-flops, R-S flip-flops, etc., or combination(s) thereof. However, in some examples, any other data sampling circuitry can be used in addition to, or in place of, the flip-flop circuits 230.

In the illustrated example of FIG. 1, the receiver circuitry 120 of the top die 110 includes an example first-in-first-out (FIFO) buffer circuit 240 that is coupled to the clock input 140 and the data input(s) 145 of the top die 110. The FIFO buffer circuit 240 also includes the one or more data outputs 220. As described above, because the clock signal at the clock input 140 and the data signal(s) at the data input(s) 145 are source-synchronous, the FIFO buffer circuit 240 can use the clock signal at the clock input 140 to sample the data signal(s) at the data input(s) 145 to produce the output data signal(s) at the data output(s) 220 without the use of setup and hold times, or other clock synchronization operations. Such data sampling facilitates reduced latency and higher throughput relative to standard synchronous data transfer. As described above, the output data signal(s) from the data output(s) 220 can be provided to any data consumer circuitry, such as, but not limited to, one or more CPUs, one or more GPUs, one or more hardware accelerators, one or more processor cores, one or more memories or memory circuits, one or more caches or cache circuits, one or more network interfaces or network interface circuits/cards, etc., in the top die 110 or another die of the die stack 100.

In the illustrated example, the FIFO buffer circuit 240 implements a clock domain crossing (CDC) FIFO buffer circuit 240 that permits the output data signal(s) to be clocked out of the data output(s) 220 based on a different clock signal than the clock signal at the clock input 140 (which is the clock signal used by the FIFO buffer circuit 240 to sample the input data signal(s) at the data input(s) 145). As such, the FIFO buffer circuit 240 has a second example clock input 245 to accept a second clock signal from example clock distribution circuitry 250 of the top die 110. For example, the clock distribution circuity 250 can be implemented by PLL circuitry and/or other clock generation/distribution circuitry, and the second clock signal can be a reference clock signal used to drive circuitry, such as one or more CPUs, GPUs, accelerators, cores, etc., of the top die 110. In the illustrated example, the FIFO buffer circuit 240 uses the second clock signal at the second clock input 245 to clock out the output data signal(s) at the data output(s) 245 such that the output data signal(s) are synchronized with the other circuitry of the top die 110. Although FIG. 1 illustrates a FIFO buffer circuit 240 being used to receive and sample the input data signal(s) at the data input(s) 145, in some examples, any circuitry capable of sampling input data signal(s) to produce corresponding output data signal(s)/sample(s) can be used to implement the receiver circuitry 120 of the top die 110.

Based on the foregoing, the 3D die stack 100 of FIG. 1 implements a source-synchronous data interface between the base die 105 and the top die 110. Furthermore, the clock signal of the source-synchronous data interface (e.g., corresponding to the clock output 125 of the base die 105 and the clock input 140 of the top die) is placed in the group of microbumps 135 and 150 of the interconnect 155 such the clock and data signal(s) transferred from the base die 105 to the top die 105 over the source-synchronous data interface are subjected to the same or substantially similar propagation delays. Thus, the source-synchronous data interface is able to transfer a potentially large number of high-speed data signals over the source-synchronous data interface (e.g. such as 9 x 8 x 6 - 1 = 431 data signals in the example of FIG. 1) with one clock signal, which can be beneficial for data intensive applications, such as AI applications, video/graphics processing applications, etc.

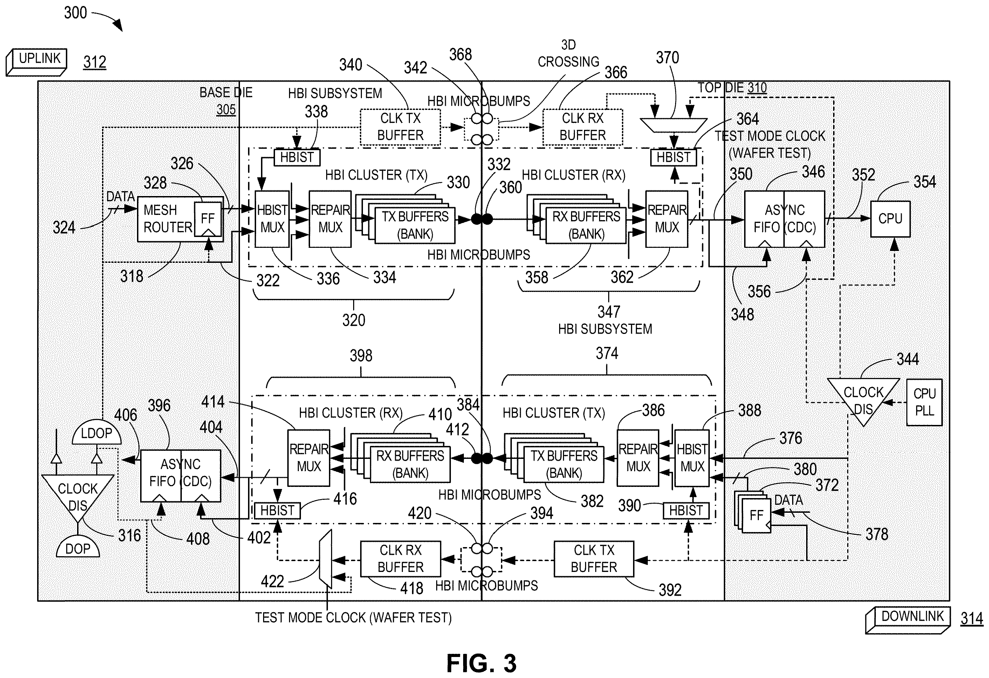

An example circuit diagram of another example 3D die stack 300, which may be used to implement the 3D die stack 100 of FIG. 1, is illustrated in FIG. 3. The 3D die stack 300 can be included in an integrated circuit or any other device, chip, apparatus, etc., such as SoC device, an ASIC, etc. In the example of FIG. 3, the 3D die stack 300 includes an example base die 305 and an example top die 310 that implement two example source-synchronous data interfaces that support single data rate (SDR) operation. In the illustrated example, the two example source-synchronous data interfaces include an example uplink source-synchronous data interface 312 and an example downlink source-synchronous data interface 314.

In the example circuit diagram of FIG. 3, the base die 305 includes example clock distribution circuitry 316, example router circuitry 318 and example transmit interconnect circuitry 320 that implement the transmitter-side of the uplink source-synchronous data interface 312. In some examples, the clock distribution circuitry 316, the router circuitry 318 and the transmit interconnect circuitry 320 correspond to the transmitter circuitry 115 of FIG. 1. For example, the clock distribution circuitry 316, also referred to as the clock distribution circuit 316, generates the reference clock signal for the uplink source-synchronous data interface 312 of the 3D die stack 300. As such, the clock distribution circuit 316 includes or is coupled to an example clock output 322 of the base die 305 to provide the clock signal of the uplink source-synchronous data interface 312 to the top die 310. The clock distribution circuit 316 of the illustrated example includes phase locked loop (PLL) circuitry and one or more buffer circuits (also referred to as drop-off-points (DOPs) and local DOPs (LDOPS)) to generate and distribute the clock signal to the clock output 322. However, any clock generation and/or distribution circuitry can be used to implement the clock distribution circuit 316.

In some examples, two or more elements of FIG. 3 are coupled to one another if they are in circuit with one another, in communication with one another, etc., directly or indirectly via one or more intermediate elements.

The router circuitry 318, also referred to as the router circuit 318, includes one or more data inputs 324 that accept respective input data signal(s) to be provided (e.g., routed) to one or more example data outputs 326 of base die 305 for transmission to the top die 310. The router circuitry 318 further synchronizes the data signals at the data inputs 324 to the reference clock signal at the clock output 322 to facilitate source-synchronous data transfer over the uplink source-synchronous data interface 312. For example, the router circuitry 318 includes example flip-flop circuits 328 to sample the data signal(s) at the data input(s) 324 based on the reference clock signal at the clock output 322 to produce the output data signal(s) at the data output(s) 326 that are synchronized with the reference clock signal, thereby achieving the synchronized clock and data signals of the uplink source-synchronous data interface 312. As described above, the inputs data signal(s) applied to the data input(s) 324 can come from any data source or combination of data sources, such as, but not limited to, one or more memories or memory circuits, caches or cache circuits, network interfaces or network interface circuits/cards, CPUs, GPUs, processor cores, hardware accelerators, etc., in the base die 305 or another die of the die stack 300. The flip-flop circuits 328 of the illustrated example can be implemented by any number(s) and/or type(s) of flip-flip circuits, such as, but not limited to, D flip-flips, J-K flip-flops, R-S flip-flops, etc., or combination(s) thereof. However, in some examples, any other data routing/distribution circuitry and/or sampling circuitry can be used in addition to, or in place of, the router circuitry 318 and/or the flip-flop circuits 328.

The transmit interconnect circuitry 320 includes one or more example transmit buffer circuits 330 to couple the clock output 322 and the data output(s) 326 of the base die 305 to corresponding example microbumps 332 of the base die 305 that are associated with the uplink source-synchronous data interface 312. For example, a first one of the transmit buffer circuits 330 may couple the clock output 322 to a first one of the microbumps 332 of the base die 305, and a second one of the transmit buffer circuits 330 may couple one of the data output(s) 326 to a second one of the microbumps 332 of the base die 305. The transmit buffer circuits 330 can be implemented by any type(s) or number(s) of buffer circuits, wires, conductive traces, paths, etc. The microbumps 332 can correspond to, and be arranged in a manner similar to, or the same as, the microbumps 135 of FIG. 1. As such, one of the microbumps 332 can be coupled to the clock output 322 and other ones of the microbumps 332 can be coupled to respective ones of the data output(s) 326. For example, the one of the microbumps 332 coupled to the clock output 322 can be an interior microbump (e.g., located centrally) relative to the other ones of the microbumps 332 coupled to respective ones of the data output(s) 326. As another example, the microbumps 332 can be arranged as a grid of cells similar to or the same as the example of FIG. 1 such that the one of the microbumps 332 coupled to the clock output 322 is in an interior cell of microbumps (e.g., located centrally) relative to the other cells of microbumps coupled to respective ones of the data output(s) 326. (Thus, the single dot labeled 332 in FIG. 3 may represent any number of microbumps 332.)

The transmit interconnect circuitry 320 also includes an example repair multiplexer circuit 334 that can couple, or multiplex, the clock output 322 and the data output(s) 326 to different microbumps 332 as appropriate to bypass broken or defective microbump connections. The transmit interconnect circuitry 320 further includes an example built-in self-test (BIST) multiplexer circuit 336 to support injection of test signals generated by example BIST circuitry 338 into the clock output 322 and/or the data output(s) 326 to support BIST operations.

In the illustrated example, the base die 305 also includes an example clock transmit buffer circuit 340 to couple the clock output 322 of the uplink source-synchronous data interface 312 to one or more microbumps 342 separate from the microbumps 332 associated with the uplink source-synchronous data interface 312. The clock transmit buffer circuit 340 and the microbump(s) 342 provide a separate (and potentially isolated) path for transmitting the reference clock signal for the uplink source-synchronous data interface 312 from the base die 305 to the top die 310 for use during testing.

In the example circuit diagram of FIG. 3, the top die 310 includes example clock distribution circuitry 344, example FIFO buffer circuitry 346 and example receive interconnect circuitry 347 that implement the receiver-side of the uplink source-synchronous data interface 312. In some examples, the clock distribution circuitry 344, the FIFO buffer circuitry 346 and the receive interconnect circuitry 347 correspond to the receiver circuitry 120 of FIG. 1. For example, the FIFO buffer circuitry 346, also referred to as the FIFO buffer circuit 346, is coupled to an example clock input 348 and example data input(s) 350 of the top die 310. The clock input 348 and the data input(s) 350 receive the reference clock signal and data signal(s) being transmitted by the base die 305 to the top die 310 via the uplink source-synchronous data interface 312 of the 3D die stack 300. The FIFO buffer circuit 346 also includes the one or more data outputs 352. As described above, because the clock signal at the clock input 348 and the data signal(s) at the data input(s) 350 are source-synchronous, the FIFO buffer circuit 346 can use the clock signal at the clock input 348 to sample the data signal(s) at the data input(s) 350 to produce the output data signal(s) at the data output(s) 352 without the use of setup and hold times, or other clock synchronization operations. Such data sampling facilitates reduced latency and higher throughput relative to standard synchronous data transfer. As described above, the output data signal(s) from the data output(s) 352 can be provided to any data consumer circuitry, such as, but not limited to, one or more example CPUs 354, one or more GPUs, one or more hardware accelerators, one or more processor cores, one or more memories or memory circuits, one or more caches or cache circuits, one or more network interfaces or network interface circuits/cards etc., in the top die 310 or another die of the die stack 300.

In the illustrated example, the FIFO buffer circuit 346 implements a CDC FIFO buffer circuit 346 that permits the output data signal(s) to be clocked out of the data output(s) 352 based on a different clock signal than the clock signal at the clock input 348 (which is the clock signal used by the FIFO buffer circuit 346 to sample the input data signal(s) at the data input(s) 350). As such, the FIFO buffer circuit 346 has a second example clock input 356 to accept a second clock signal from the clock distribution circuitry 344 of the top die 310. For example, the clock distribution circuitry 344 can be implemented by PLL circuitry and/or other clock generation/distribution circuitry, and the second clock signal can be a reference clock signal for driving circuitry, such as the CPUs 354 and/or GPUs, accelerators, cores, etc., of the top die 310. In the illustrated example, the FIFO buffer circuit 346 uses the second clock signal at the second clock input 356 to clock out the output data signal(s) at the data output(s) 352 such that the output data signal(s) are synchronized with the other circuitry of the top die 310.

The receive interconnect circuitry 347 includes one or more example receive buffer circuits 358 to couple the clock input 348 and the data input(s) 350 of the top die 310 to corresponding example microbumps 360 of the top die 310 that are associated with the uplink source-synchronous data interface 312. For example, a first one of the receive buffer circuits 358 may couple the clock input 348 to a first one of the microbumps 360 of the top die 310, and a second one of the receive buffer circuits 358 may couple one of the data input(s) 350 to a second one of the microbumps 360 of the top die 310. The receive buffer circuits 358 can be implemented by any type(s) or number(s) of buffer circuits, wires, conductive traces, paths, etc. The microbumps 360 can correspond to, and be arranged in a manner similar to, or the same as, the microbumps 150 of FIG. 1. As such, one of the microbumps 360 can be coupled to the clock input 348 and other ones of the microbumps 360 can be coupled to respective ones of the data input(s) 350. For example, the one of the microbumps 360 coupled to the clock input 348 can be an interior microbump (e.g., located centrally) relative to the other ones of the microbumps 360 coupled to respective ones of the data input(s) 350. As another example, the microbumps 360 can be arranged as a grid of cells similar to or the same as the example of FIG. 1 such that the one of the microbumps 360 coupled to the clock input 348 is in an interior cell of microbumps (e.g., located centrally) relative to the other cells of microbumps coupled to respective ones of the data input(s) 350. (Thus, the single dot labeled 360 in FIG. 3 may represent any number of microbumps 332.) Furthermore, the microbumps 332 of the base die 305 and the microbumps 360 of the top die 310 are arranged such that the one of the microbumps 332 coupled to the clock output 322 of the base die 305 is bonded to the one of the microbumps 360 coupled to the clock input 348 of the top die 310, and such that the other microbumps 332 and microbumps 360 coupled respectively to paired data output(s) 326 and data input(s) 350 properly bond together when the dies 305 and 310 are bonded into the die stack 300.

The receiver interconnect circuitry 347 also includes an example repair multiplexer circuit 362 that can couple, or multiplex, the clock input 348 and the data input(s) 350 to different microbumps 360 as appropriate to bypass broken or defective microbump connections. The receive interconnect circuitry 347 further includes example BIST circuitry 364 to sample the received data and clock signals of the uplink source-synchronous data interface 312 during BIST operations.

In the illustrated example, the top die 310 also includes an example clock receive buffer circuit 366 to couple the clock input 348 of the uplink source-synchronous data interface 312 to one or more microbumps 368 separate from the microbumps 360 associated with the uplink source-synchronous data interface 312. The clock receive buffer circuit 366 and microbump(s) 368 provide a separate (and potentially isolated path) for receiving the reference clock signal of the uplink source-synchronous data interface 312 from the base die 305 for use during testing. Furthermore, the microbump(s) 368 of the top die 310 and the microbump(s) 342 of the base die 305 are arranged such that they are bonded together when the top die 310 and the base die 305 are bonded together.

In the illustrated example, the top die 310 also includes an example clock multiplexer circuit 370 coupled via the clock receive buffer circuit 366 to the microbump(s) 368 to receive the reference clock signal of the uplink source-synchronous data interface 312. The clock multiplexer circuit 370 is also coupled to the clock distribution circuitry 344 of the top die 310 to receive the local clock signal generated by the top die 310. The clock multiplexer circuit 370 is further coupled to the BIST circuity 364 to permit selection between the reference clock signal of the uplink source-synchronous data interface 312 or the local clock signal of the top die 310 to clock the BIST circuity 364 for use in testing the receiver side of the uplink source-synchronous data interface 312. For example, the clock multiplexer circuit 370 may select the local clock signal of the top die 310 before the top die 310 is bonded with the base die 305 to permit standalone testing of the top die 310. However, after the top die 310 is bonded with the base die 305, the clock multiplexer circuit 370 may select the reference clock signal of the uplink source-synchronous data interface 312 to drive the BIST circuity 364.

With respect to the downlink source-synchronous data interface 314 of the die stack 300, in the example circuit diagram of FIG. 3, the top die 310 includes the clock distribution circuitry 344, example flip-flop circuitry 372 and example transmit interconnect circuitry 374 that implement the transmitter-side of the downlink source-synchronous data interface 314. For example, the clock distribution circuitry 344, also referred to as the clock distribution circuit 344, generates the reference clock signal for the downlink source-synchronous data interface 314 of the 3D die stack 300. As such, the clock distribution circuit 344 includes or is coupled to an example clock output 376 of the top die 310 to provide the clock signal of the downlink source-synchronous data interface 314 to the bottom die 305.

The flip-flop circuitry 372, also referred to as the flip-flop circuit 372, includes one or more data inputs 378 that accept respective input data signal(s) to be provided (e.g., routed) to one or more example data outputs 380 of top die 310 for transmission to the base die 305. The flip-flop circuitry 372 further synchronizes the data signals at the data inputs 378 to the reference clock signal at the clock output 376 to facilitate source-synchronous data transfer over the downlink source-synchronous data interface 314. For example, the flip-flop circuitry 372 samples the data signal(s) at the data input(s) 378 based on the reference clock signal at the clock output 376 to produce the output data signal(s) at the data output(s) 380 that are synchronized with the reference clock signal, thereby achieving the synchronized clock and data signals of the downlink source-synchronous data interface 314. The inputs data signal(s) applied to the data input(s) 378 can come from any data source or combination of data sources, such as, but not limited to, the CPU(s) 354, one or more GPUs, one or more hardware accelerators, one or more processor cores, one or more memories or memory circuits, one or more caches or cache circuits, one or more network interfaces or network interface circuits/cards, etc., in the top die 310 or another die of the die stack 300. The flip-flop circuits 372 of the illustrated example can be implemented by any number(s) and/or type(s) of flip-flip circuits, such as, but not limited to, D flip-flips, J-K flip-flops, R-S flip-flops, etc., or combination(s) thereof. However, in some examples, any other data routing/distribution circuitry and/or data sampling circuitry can be used in addition to, or in place of, the flip-flop circuits 372.

The transmit interconnect circuitry 374 includes one or more example transmit buffer circuits 382 to couple the clock output 376 and the data output(s) 380 of the top die 310 to corresponding example microbumps 384 of the top die 310 that are associated with the downlink source-synchronous data interface 314. For example, a first one of the transmit buffer circuits 382 may couple the clock output 376 to a first one of the microbumps 384 of the top die 310, and a second one of the transmit buffer circuits 382 may couple one of the data output(s) 380 to a second one of the microbumps 384 of the top die 310. The transmit buffer circuits 382 can be implemented by any type(s) or number(s) of buffer circuits, wires, conductive traces, paths, etc. The microbumps 384 can correspond to, and be arranged in a manner similar to, or the same as, the microbumps 150 of FIG. 1. As such, one of the microbumps 384 can be coupled to the clock output 376 and other ones of the microbumps 384 can be coupled to respective ones of the data output(s) 380. For example, the one of the microbumps 384 coupled to the clock output 376 can be an interior microbump (e.g., located centrally) relative to the other ones of the microbumps 384 coupled to respective ones of the data output(s) 380. As another example, the microbumps 384 can be arranged as a grid of cells similar to or the same as the example of FIG. 1 such that the one of the microbumps 384 coupled to the clock output 376 is in an interior cell of microbumps (e.g., located centrally) relative to the other cells of microbumps coupled to respective ones of the data output(s) 380. (Thus, the single dot labeled 384 in FIG. 3 may represent any number of microbumps 384.)

The transmit interconnect circuitry 374 also includes an example repair multiplexer circuit 386 that can couple, or multiplex, the clock output 376 and the data output(s) 380 to different microbumps 384 as appropriate to bypass broken or defective microbump connections. The transmit interconnect circuitry 374 further includes an example BIST multiplexer circuit 388 to support injection of test signals generated by example BIST circuitry 390 into the clock output 376 and/or the data output(s) 380 to support BIST operations.

In the illustrated example, the top die 310 also includes an example clock transmit buffer circuit 392 to couple the clock output 376 of the downlink source-synchronous data interface 314 to one or more microbumps 394 separate from the microbumps 384 associated with the downlink source-synchronous data interface 314. The clock transmit buffer circuit 392 and the microbump(s) 394 provide a separate (and potentially isolated) path for transmitting the reference clock signal for the downlink source-synchronous data interface 314 from the top die 310 to the base die 305 for use during testing.

In the example circuit diagram of FIG. 3, the base die 305 includes the clock distribution circuitry 316, example FIFO buffer circuitry 396 and example receive interconnect circuitry 398 that implement the receiver-side of the downlink source-synchronous data interface 314. For example, the FIFO buffer circuitry 396, also referred to as the FIFO buffer circuit 396, is coupled to an example clock input 402 and example data input(s) 404 of the base die 305. The clock input 402 and the data input(s) 404 receive the reference clock signal and data signal(s) being transmitted by the top die 310 to the base die 305 via the downlink source-synchronous data interface 314 of the 3D die stack 300. The FIFO buffer circuit 396 also includes the one or more data outputs 406. As described above, because the clock signal at the clock input 402 and the data signal(s) at the data input(s) 404 are source-synchronous, the FIFO buffer circuit 396 can use the clock signal at the clock input 402 to sample the data signal(s) at the data input(s) 404 to produce the output data signal(s) at the data output(s) 406 without the use of setup and hold times, or other clock synchronization operations. Such data sampling facilitates reduced latency and higher throughput than standard synchronous data transfer. The output data signal(s) from the data output(s) 406 can be provided to any data consumer circuitry, such as, but not limited to, one or more memories or memory circuits, one or more caches or cache circuits, one or more network interfaces or network interface circuits/cards, one or more CPUs, one or more GPUs, one or more hardware accelerators, one or more processor cores, etc., in the base die 305 or another die of the die stack 300.

In the illustrated example, the FIFO buffer circuit 396 implements a CDC FIFO buffer circuit 396 that permits the output data signal(s) to be clocked out of the data output(s) 406 based on a different clock signal than the clock signal at the clock input 402 (which is the clock signal used by the FIFO buffer circuit 396 to sample the input data signal(s) at the data input(s) 404). As such, the FIFO buffer circuit 396 has a second example clock input 408 to accept a second clock signal from the clock distribution circuitry 316 of the base die 305. For example, the second clock signal can be a local clock signal generated by the clock distribution circuitry 344 to drive the circuitry of the base die 305. In the illustrated example, the FIFO buffer circuit 396 uses the second clock signal at the second clock input 408 to clock out the output data signal(s) at the data output(s) 406 such that the output data signal(s) are synchronized with the other circuitry of the base die 305.

The receive interconnect circuitry 398 includes one or more example receive buffer circuits 410 to couple the clock input 402 and the data input(s) 404 of the base die 305 to corresponding example microbumps 412 of the base die 305 that are associated with the downlink source-synchronous data interface 314. For example, a first one of the receive buffer circuits 410 may couple the clock input 402 to a first one of the microbumps 412 of the base die 305, and a second one of the receive buffer circuits 410 may couple one of the data input(s) 404 to a second one of the microbumps 412 of the base die 305. The receive buffer circuits 410 can be implemented by any type(s) or number(s) of buffer circuits, wires, conductive traces, paths, etc. The microbumps 412 can correspond to, and be arranged in a manner similar to, or the same as, the microbumps 135 of FIG. 1. As such, one of the microbumps 412 can be coupled to the clock input 402 and other ones of the microbumps 412 can be coupled to respective ones of the data input(s) 404. For example, the one of the microbumps 412 coupled to the clock input 402 can be an interior microbump (e.g., located centrally) relative to the other ones of the microbumps 412 coupled to respective ones of the data input(s) 404. As another example, the microbumps 412 can be arranged as a grid of cells similar to or the same as the example of FIG. 1 such that the one of the microbumps 412 coupled to the clock input 404 is in an interior cell of microbumps (e.g., located centrally) relative to the other cells of microbumps coupled to respective ones of the data input(s) 412. (Thus, the single dot labeled 412 in FIG. 3 may represent any number of microbumps 412.) Furthermore, the microbumps 412 of the base die 305 and the microbumps 384 of the top die 310 are arranged such that the one of the microbumps 384 coupled to the clock output 376 of the top die 310 is bonded to the one of the microbumps 412 coupled to the clock input 404 of the base die 305, and such that the other microbumps 384 and microbumps 412 coupled respectively to paired data output(s) 380 and data input(s) 404 properly bond together when the dies 305 and 310 are bonded into the die stack 300.

The receiver interconnect circuitry 398 also includes an example repair multiplexer circuit 414 that can couple, or multiplex, the clock input 402 and the data input(s) 404 to different microbumps 412 as appropriate to bypass broken or defective microbump connections. The receive interconnect circuitry 398 further includes example BIST circuitry 416 to sample the received data and clock signals of the downlink source-synchronous data interface 314 during BIST operations.

In the illustrated example, the base die 305 also includes an example clock receive buffer circuit 418 to couple the clock input 404 of the downlink source-synchronous data interface 314 to one or more microbumps 420 separate from the microbumps 412 associated with the downlink source-synchronous data interface 314. The clock receive buffer circuit 418 and the microbump(s) 420 provide a separate (and potentially isolated path) for receiving the reference clock signal of the downlink source-synchronous data interface 314 from the top die 310 for use during testing. Furthermore, the microbump(s) 394 of the top die 310 and the microbump(s) 420 of the base die 305 are arranged such that they are bonded together when the top die 310 and the base die 305 are bonded together.

In the illustrated example, the base die 305 also includes an example clock multiplexer circuit 422 coupled via the clock receive buffer circuit 418 to the microbump(s) 420 to receive the reference clock signal of the downlink source-synchronous data interface 314. The clock multiplexer circuit 422 is also coupled to the clock distribution circuitry 316 of the base die 305 to receive the local clock signal generated by the base die 305. The clock multiplexer circuit 422 is further coupled to the BIST circuity 416 to permit selection between the reference clock signal of the downlink source-synchronous data interface 314 or the local clock signal of the base die 305 to clock the BIST circuity 416 for use in testing the receiver side of the downlink source-synchronous data interface 314. For example, the clock multiplexer circuit 422 may select the local clock signal of the base die 305 before the base die 305 is bonded with the top die 310 to permit standalone testing of the base die 305. However, after the base die 305 is bonded with the top die 310, the clock multiplexer circuit 422 may select the reference clock signal of the downlink source-synchronous data interface 314 to drive the BIST circuity 416.

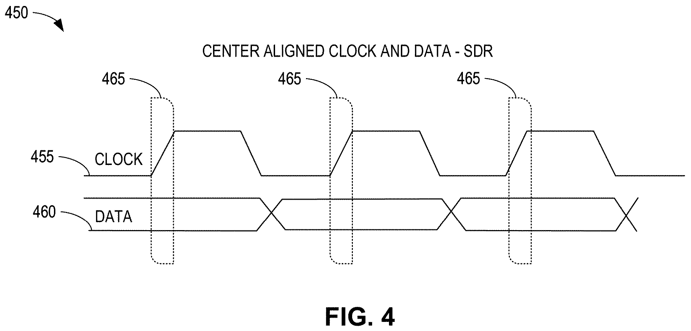

As noted above, the uplink source-synchronous data interface 312 and the downlink source-synchronous data interface 314 of the 3D die stack 300 of FIG. 3 implement single data rate (SDR) data transfer. In SDR data transfer, one data bit (or data pulse) is transferred per period of the clock signal. FIG. 4 includes example waveforms 450 that illustrate example SDR operation of the uplink source-synchronous data interface 312 of FIG. 3. (In some examples, SDR operation of the downlink source-synchronous data interface 314 of FIG. 3 exhibits similar waveforms.)

The waveforms 450 depicted in the example of FIG. 4 include an example clock waveform 455 and an example data waveform 460. The clock waveform 455 corresponds to the reference clock signal of the uplink source-synchronous data interface 312 that is produced at the clock output 322 of the base die 305 and received at the clock input 348 of the top die 310. The data waveform 460 corresponds to one of the data signals of the uplink source-synchronous data interface 312 that is produced at one of the data outputs 326 of the base die 305 and received at a corresponding one of the data inputs 350 of the top die 310. In the illustrated example, the router circuitry 318 of the base die 305 synchronizes the clock signal and the data signal such that one data bit (or data pulse) is transferred per period of the clock signal, as illustrated by the clock waveform 455 and the data waveform 460.

Furthermore, in the illustrated example of FIG. 4, the router circuitry 318 of the base die 305 and/or the FIFO buffer circuitry 396 of the top die 310 delays the clock signal relative to the data signal such that rising edges of the clock signal (e.g., corresponding to the example regions 465 of the waveforms 450) are aligned within (e.g., at or near the center of) the data bits (or data pulses) of the data signal. With such a delay, the FIFO buffer circuitry 396 can sample the data signal at sample times corresponding to the rising edges of the clock signal without the use of setup and hold times.

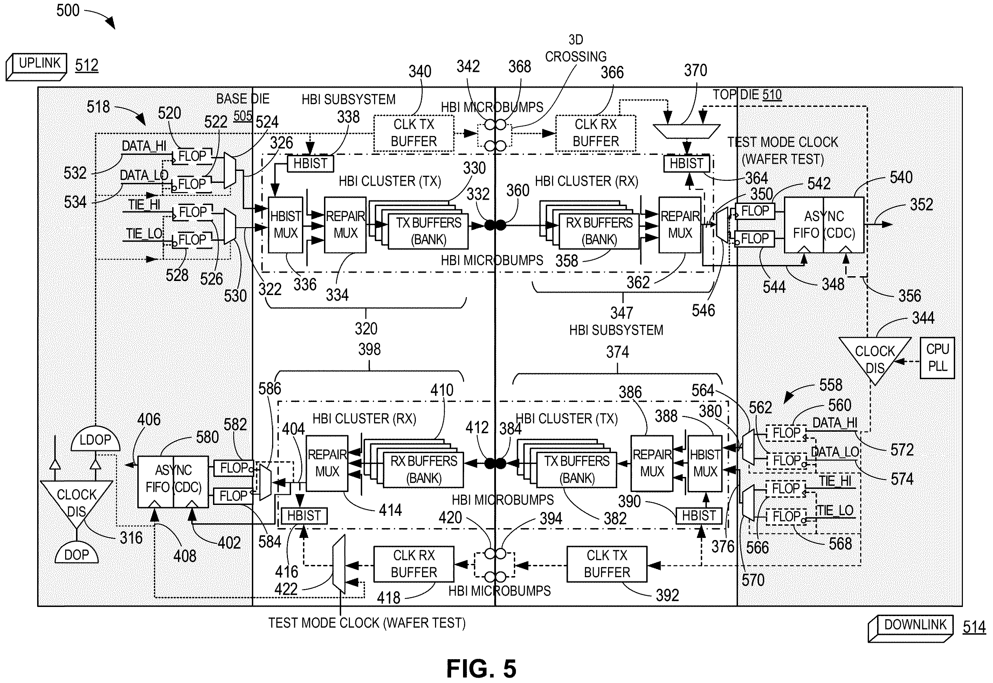

An example circuit diagram of yet another example 3D die stack 500, which may be used to implement the 3D die stack 100 of FIG. 1, is illustrated in FIG. 5. The 3D die stack 500 can be included in an integrated circuit or any other device, chip, apparatus, etc., such as SoC device, an ASIC, etc. In the example of FIG. 5, the 3D die stack 500 includes an example base die 505 and an example top die 510 that implement two example source-synchronous data interfaces that support double data rate (DDR) operation. In the illustrated example, the two example source-synchronous data interfaces include an example uplink source-synchronous data interface 512 and an example downlink source-synchronous data interface 514.

The example 3D die stack 500 of FIG. 5 includes several elements in common with the example 3D die stack 300 of FIG. 3. Such elements include the clock distribution circuitry 316, the transmit interconnect circuitry 320, the clock output 322, the data output(s) 326, the transmit buffer circuits 330, the microbumps 332, the repair multiplexer circuit 334, the multiplexer circuit 336, the BIST circuitry 338, the clock transmit buffer circuit 340, the microbump(s) 342, the clock distribution circuitry 344, the receive interconnect circuitry 347, the clock input 348, the data input(s) 350, the data output(s) 352, the clock input 356, the receive buffer circuits 358, the microbumps 360, the repair multiplexer circuit 362, the BIST circuitry 364, the clock receive buffer circuit 366, the microbump(s) 368, the clock multiplexer circuit 370, the transmit interconnect circuitry 374, the clock output 376, the data output(s) 380, the transmit buffer circuits 382, the microbumps 384, the repair multiplexer circuit 386, the BIST multiplexer circuit 388, the BIST circuitry 390, the clock transmit buffer circuit 392, the microbump(s) 394, the receive interconnect circuitry 398, the clock input 402, the data input(s) 404, the data output(s) 406, the clock input 408, the receive buffer circuits 410, the microbumps 412, the repair multiplexer circuit 414, the BIST circuitry 416, the clock receive buffer circuit 418, the microbump(s) 420, and the clock multiplexer circuit 422. The descriptions of those elements are provided above in connection with the description of FIG. 3 and are not repeated in the description of FIG. 5.

However, in contrast with the example 3D die stack 300 of FIG. 3, the base die 505 of the example 3D die stack 500 of FIG. 5 includes example router circuitry 518 that synchronizes data transitions of the data signals at the data outputs 326 with both the rising edges and falling edges of the reference clock signal at the clock output 322, thereby implement DDR data transfer over the uplink source-synchronous data interface 512. To achieve such synchronization, the router circuitry 518, also referred to as the router circuit 518, includes example data flip-flops circuits 520 and 522, an example data multiplexer circuit 524, example clock flip-flops circuits 526 and 528, and an example clock multiplexer circuit 530. The flip-flops circuit(s) 520 include one or more data inputs 532 that accept respective first data signal(s) to be synchronized with rising edges of the reference clock signal at the data outputs 326. For example, the flip-flops circuit(s) 520 sample the data signal(s) at rising edges of the reference clock signal to produce first output data signal(s) at the data outputs 326 that are synchronized with rising edges of the reference clock signal. The flip-flops circuit(s) 522 include one or more data inputs 534 that accept respective second data signal(s) to be synchronized with falling edges of the reference clock signal at the data outputs 326. Similarly, the flip-flops circuit(s) 522 sample the data signal(s) at falling edges of the reference clock signal to produce second output data signal(s) at the data outputs 326 that are synchronized with falling edges of the reference clock signal. The data multiplexer circuit 524 switches between the output(s) of the flip-flops circuit(s) 520 and the output(s) of the flip-flops circuit(s) 522 to produce outputs signal(s) at the data output(s) 326 the achieve DDR data transfer, with data transitions synchronized with both the rising edges and falling edges of the reference clock signal at the clock output 322.

In the illustrated example of FIG. 5, the router circuitry 518 also includes the clock flip-flops circuits 526 and 528, and the clock multiplexer circuit 530, to cause the reference clock signal to experience the same, or similar, propagation delay as the data signal(s), thereby maintaining proper synchronization alignment between the clock and data signals of the uplink source-synchronous data interface 512. Also, as described above, the inputs data signal(s) applied to the data input(s) 532 and 534 can come from any data source or combination of data sources, such as, but not limited to, one or more memories or memory circuits, caches or cache circuits, network interfaces or network interface circuits/cards, CPUs, GPUs, processor cores, hardware accelerators, etc., in the base die 505 or another die of the die stack 500.

Also, in contrast with the example 3D die stack 300 of FIG. 3, the top die 510 of the example 3D die stack 500 of FIG. 5 includes an example FIFO buffer circuit 540, such as an example, CDC FIFO buffer circuit 540, with inputs that are coupled to example flip-flop circuits 542 and 544, and an example demultiplexer circuit 546. The demultiplexer circuit 546 and the flip-flop circuits 542 and 544 enable the CDC FIFO buffer circuit 540 to properly sample and output the DDR signal(s) received at at the data input(s) 350. For example, the demultiplexer circuit 546 switches between portions of the data signal(s) to be sampled at the rising edges of the reference clock signal and portions of the data signal(s) to be sampled at the falling edges of the reference clock signal. The demultiplexer circuit 546 provides the portions of the data signal(s) to be sampled at the rising edges of the reference clock signal to the flip-flop circuit(s) 542, and provides the portions of the data signal(s) to be sampled at the falling edges of the reference clock signal to the flip-flop circuit(s) 544. The CDC FIFO buffer circuit 540 then operates as described above to sample the data signal(s) captured by the flip-flop circuit(s) 542 and 544 to produce the output data signal(s) at the data output(s) 352.

In some examples, two or more elements of FIG. 5 are coupled to one another if they are in circuit with one another, in communication with one another, etc., directly or indirectly via one or more intermediate elements.

Furthermore, in contrast with the example 3D die stack 300 of FIG. 3, the top die 510 of the example 3D die stack 500 of FIG. 5 includes example router circuitry 558 that synchronizes data transitions of the data signals at the data outputs 380 with both the rising edges and falling edges of the reference clock signal at the clock output 376, thereby implement DDR data transfer over the downlink source-synchronous data interface 514. To achieve such synchronization, the router circuitry 558, also referred to as the router circuit 558, includes example data flip-flops circuits 560 and 562, an example data multiplexer circuit 564, example clock flip-flops circuits 566 and 568, and an example clock multiplexer circuit 570. The flip-flops circuit(s) 560 include one or more data inputs 572 that accept respective first data signal(s) to be synchronized with rising edges of the reference clock signal at the data outputs 380. For example, the flip-flops circuit(s) 560 sample the data signal(s) at rising edges of the reference clock signal to produce first output data signal(s) at the data outputs 380 that are synchronized with rising edges of the reference clock signal. The flip-flops circuit(s) 562 include one or more data inputs 574 that accept respective second data signal(s) to be synchronized with falling edges of the reference clock signal at the data outputs 380. Similarly, the flip-flops circuit(s) 562 sample the data signal(s) at falling edges of the reference clock signal to produce second output data signal(s) at the data outputs 380 that are synchronized with falling edges of the reference clock signal. The data multiplexer circuit 564 switches between the output(s) of the flip-flops circuit(s) 560 and the output(s) of the flip-flops circuit(s) 562 to produce outputs signal(s) at the data output(s) 380 the achieve DDR data transfer, with data transitions synchronized with both the rising edges and falling edges of the reference clock signal at the clock output 376.

In the illustrated example of FIG. 5, the router circuitry 558 also includes the clock flip-flops circuits 566 and 568, and the clock multiplexer circuit 570, to cause the reference clock signal to experience the same, or similar, propagation delay as the data signal(s), thereby maintaining proper synchronization alignment between the clock and data signals of the downlink source-synchronous data interface 514. Also, as described above, the inputs data signal(s) applied to the data input(s) 572 and 574 can come from any data source or combination of data sources, such as, but not limited to, one or more memories or memory circuits, caches or cache circuits, network interfaces or network interface circuits/cards, CPUs, GPUs, processor cores, hardware accelerators, etc., in the top die 510 or another die of the die stack 500.

Also, in contrast with the example 3D die stack 300 of FIG. 3, the bottom die 505 of the example 3D die stack 500 of FIG. 5 includes an example FIFO buffer circuit 580, such as an example, CDC FIFO buffer circuit 580, with inputs that are coupled to example flip-flop circuits 582 and 584, and an example demultiplexer circuit 586. The demultiplexer circuit 586 and the flip-flop circuits 582 and 584 enable the CDC FIFO buffer circuit 580 to properly sample and output the DDR signal(s) received at the data input(s) 440. For example, the demultiplexer circuit 586 switches between portions of the data signal(s) to be sampled at the rising edges of the reference clock signal and portions of the data signal(s) to be sampled at the falling edges of the reference clock signal. The demultiplexer circuit 586 provides the portions of the data signal(s) to be sampled at the rising edges of the reference clock signal to the flip-flop circuit(s) 582, and provides the portions of the data signal(s) to be sampled at the falling edges of the reference clock signal to the flip-flop circuit(s) 584. The CDC FIFO buffer circuit 580 then operates as described above to sample the data signal(s) captured by the flip-flop circuit(s) 582 and 584 to produce the output data signal(s) at the data output(s) 406.

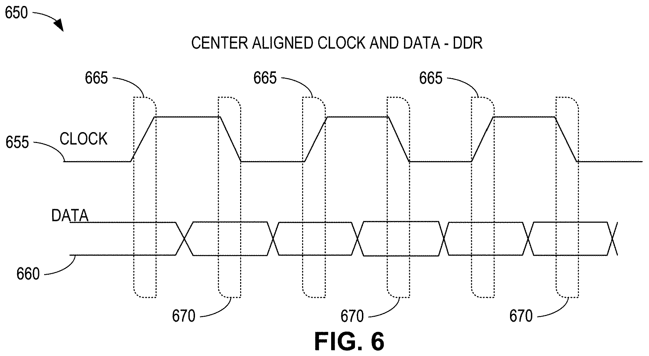

As noted above, the uplink source-synchronous data interface 512 and the downlink source-synchronous data interface 514 of the 3D die stack 500 of FIG. 5 implement double data rate (DDR) data transfer. In DDR data transfer, two data bits (or two data pulses) are transferred per period of the clock signal, with one data bit (or data pulse) synchronized with the rising clock edge and other data bit (or data pulse) synchronized with the falling clock edge. FIG. 6 includes example waveforms 650 that illustrate example DDR operation of the uplink source-synchronous data interface 512 of FIG. 5. (In some examples, DDR operation of the downlink source-synchronous data interface 514 of FIG. 5 exhibits similar waveforms.)

The waveforms 650 depicted in the example of FIG. 6 include an example clock waveform 655 and an example data waveform 660. The clock waveform 655 corresponds to the reference clock signal of the uplink source-synchronous data interface 512 that is produced at the clock output 322 of the base die 505 and received at the clock input 348 of the top die 510. The data waveform 660 corresponds to one of the data signals of the uplink source-synchronous data interface 512 that is produced at one of the data outputs 326 of the base die 505 and received at a corresponding one of the data inputs 350 of the top die 510. In the illustrated example, the router circuitry 518 of the base die 505 synchronizes the clock signal and the data signal such that two data bits (or data pulses) are transferred per period of the clock signal, as illustrated by the clock waveform 655 and the data waveform 660.

Furthermore, in the illustrated example of FIG. 6, the router circuitry 518 of the base die 505 and/or the FIFO buffer circuitry 540 of the top die 510 delays the clock signal relative to the data signal such that: (i) rising edges of the clock signal (e.g., corresponding to the example regions 665 of the waveforms 650) are aligned within (e.g., at or near the center of) the first data bits (or first data pulses) of the data signal that are synchronized with the rising edges of the clock signal, and (ii) falling edges of the clock signal (e.g., corresponding to the example regions 670 of the waveforms 650) are aligned within (e.g., at or near the center of) the second data bits (or second data pulses) of the data signal that are synchronized with the falling edges of the clock signal. With such a delay, the FIFO buffer circuitry 540 can sample the data signal at sample times corresponding to the rising edges of the clock signal without the use of setup and hold times.

The example source-synchronous data transfer techniques and associated microbump arrangements disclosed herein have been illustrated and described in the context of HBI 3D die stacks. However, the example source-synchronous data transfer techniques and associated microbump arrangements disclosed herein are not limited to HBI 3D die stacks. On the contrary, the example source-synchronous data transfer techniques and associated microbump arrangements disclosed herein can be used in 3D die stacks implemented using any die interconnect process, technology, etc.

While an example manner of implementing the 3D die stacks 100, 300 and 500 are illustrated in FIGS. 1-6, one or more of the elements, processes, and/or devices illustrated in FIGS. 1-6 may be combined, divided, re-arranged, omitted, eliminated, and/or implemented in any other way. Further, the base die 105, the top die 110, the transmitter circuitry 115, the receiver circuitry 120, the clock distribution circuit 225, the flip-flop circuits 230, the FIFO buffer circuit 240, the clock distribution circuitry 250, the base die 305, the top die 310, the clock distribution circuitry 316, the router circuitry 318, the transmit interconnect circuitry 320, the transmit buffer circuits 330, the repair multiplexer circuit 334, the multiplexer circuit 336, the BIST circuitry 338, the clock transmit buffer circuit 340, the clock distribution circuitry 344, the FIFO buffer circuitry 346, the receive interconnect circuitry 347, the receive buffer circuits 358, the repair multiplexer circuit 362, the BIST circuitry 364, the clock receive buffer circuit 366, the clock multiplexer circuit 370, the flip-flop circuitry 372, the transmit interconnect circuitry 374, the transmit buffer circuits 382, the repair multiplexer circuit 386, the BIST multiplexer circuit 388, the BIST circuitry 390, the clock transmit buffer circuit 392, the FIFO buffer circuitry 396, the receive interconnect circuitry 398, the receive buffer circuits 410, the repair multiplexer circuit 414, the BIST circuitry 416, the clock receive buffer circuit 418, the clock multiplexer circuit 422, the base die 505, the top die 510, the router circuitry 518, the FIFO buffer circuit 540, the flop circuits 542 and 544, the demultiplexer circuit 546, the router circuitry 558, the FIFO buffer circuit 580, the flip-flop circuits 582 and 584, the demultiplexer circuit 586 and/or, more generally, the example 3D die stacks 100, 300 and/or 500, may be implemented by hardware alone or by hardware in combination with software and/or firmware. Thus, for example, any of the base die 105, the top die 110, the transmitter circuitry 115, the receiver circuitry 120, the clock distribution circuit 225, the flip-flop circuits 230, the FIFO buffer circuit 240, the clock distribution circuitry 250, the base die 305, the top die 310, the clock distribution circuitry 316, the router circuitry 318, the transmit interconnect circuitry 320, the transmit buffer circuits 330, the repair multiplexer circuit 334, the multiplexer circuit 336, the BIST circuitry 338, the clock transmit buffer circuit 340, the clock distribution circuitry 344, the FIFO buffer circuitry 346, the receive interconnect circuitry 347, the receive buffer circuits 358, the repair multiplexer circuit 362, the BIST circuitry 364, the clock receive buffer circuit 366, the clock multiplexer circuit 370, the flip-flop circuitry 372, the transmit interconnect circuitry 374, the transmit buffer circuits 382, the repair multiplexer circuit 386, the BIST multiplexer circuit 388, the BIST circuitry 390, the clock transmit buffer circuit 392, the FIFO buffer circuitry 396, the receive interconnect circuitry 398, the receive buffer circuits 410, the repair multiplexer circuit 414, the BIST circuitry 416, the clock receive buffer circuit 418, the clock multiplexer circuit 422, the base die 505, the top die 510, the router circuitry 518, the FIFO buffer circuit 540, the flop circuits 542 and 544, the demultiplexer circuit 546, the router circuitry 558, the FIFO buffer circuit 580, the flip-flop circuits 582 and 584, the demultiplexer circuit 586 and/or, more generally, the example 3D die stacks 100, 300 and/or 500, could be implemented by programmable circuitry in combination with machine readable instructions (e.g., firmware or software), processor circuitry, analog circuit(s), digital circuit(s), logic circuit(s), programmable processor(s), programmable microcontroller(s), graphics processing unit(s) (GPU(s)), digital signal processor(s) (DSP(s)), ASIC(s), programmable logic device(s) (PLD(s)), and/or field programmable logic device(s) (FPLD(s)) such as FPGAs. Further still, the example 3D die stacks 100, 300 and/or 500 of may include one or more elements, processes, and/or devices in addition to, or instead of, those illustrated in FIGS. 1-6, and/or may include more than one of any or all of the illustrated elements, processes and devices.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., in circuit with, in communication with, attached, coupled, connected, joined, etc.) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that implement source-synchronous data transfer over an interconnect between dies of a 3D die stack. Disclosed systems, apparatus, articles of manufacture, and methods improve the efficiency of a computing device by synchronizing the clock with the data being transmitted over the die interconnect. Furthermore, the clock signal may be provided over a microbump connection that is interior to (e.g., centrally located relative to) the microbump connections providing the data signals over the interconnect. Using such a co-location arrangement, the clock signal and data signals are subjected to the same or similar propagation delays when being communicated between the dies of the 3D die stack, even if those dies were fabricated and/or are associated with different process technologies. As such, there may be little to no relative timing latency, shift, delay, etc., between the clock and data signals, thereby enabling the receiver die to sample the data signals based on the clock signal without the use of setup and hold times, which thereby reduces latency and improves throughput relative to synchronous data transfer. Disclosed systems, apparatus, articles of manufacture, and methods are accordingly directed to one or more improvement(s) in the operation of a machine such as a computer or other electronic and/or mechanical device.

Further examples and combinations thereof include the following. Example 1 includes an integrated circuit comprising a first die including first microbumps associated with a source-synchronous data interface of a three-dimensional (3D) die stack, a first one of the first microbumps in circuit with a clock output of the first die, a second one of the first microbumps in circuit with a data output of the first die, the clock output and the data output associated with a transmitter side of the source-synchronous data interface, and a second die including second microbumps associated with the source-synchronous data interface of the 3D die stack, a first one of the second microbumps in circuit with a clock input of the second die, a second one of the second microbumps in circuit with a data input of the second die, the clock input and the data input associated with a receiver side of the source-synchronous data interface, the first one of the first microbumps and the first one of the second microbumps bonded together and the second one of the first microbumps and the second one of the second microbumps bonded together.

Example 2 includes the integrated circuit of example 1, wherein the first microbumps are respectively in circuit with data outputs associated with the transmitter side of the source-synchronous data interface, the first microbumps are included in a region of the first die, the region defined by a perimeter defined by ones of the microbumps, and the first one of the first microbumps is an interior microbump relative to the perimeter.

Example 3 includes the integrated circuit of example 2, wherein the first one of the first microbumps is located centrally in the region of the first die.

Example 4 includes the integrated circuit of any one of examples 1 to 3, wherein the first microbumps include cells of microbumps in a grid, a first one of the cells including the first one of the first microbumps and a first plurality of microbumps that at least partially surround the first one of the first microbumps, the first plurality of microbumps in circuit with a first plurality of data outputs associated with the transmitter side of the source-synchronous data interface, other ones of the cells including respective pluralities of microbumps in circuit with respective pluralities of data outputs associated with the transmitter side of the source-synchronous data interface.

Example 5 includes the integrated circuit of example 4, wherein the first one of the cells is centrally located in the grid.

Example 6 includes the integrated circuit of any one of examples 1 to 5, wherein the first die includes a clock distribution circuit having the clock output, and a router circuit to synchronize a data signal at the data output with a clock signal at the clock output, the clock distribution circuit and the router circuit to implement the transmitter side of the source-synchronous data interface.

Example 7 includes the integrated circuit of example 6, wherein the data signal is a double data rate signal, and the router circuit is to synchronize data transitions of the data signal with both rising edges and falling edges of the clock signal.

Example 8 includes the integrated circuit of any one of examples 1 to 7, wherein the first die includes a first buffer circuit in communication with the first one of the first microbumps and the clock output of the first die, and a second buffer circuit in communication with the second one of the first microbumps to the data output of the first die.

Example 9 includes the integrated circuit of any one of examples 1 to 8, wherein the second die includes a first-in-first-out (FIFO) circuit having the clock input and the data input, the FIFO circuit to implement the receiver side of the source-synchronous data interface, the FIFO circuit to sample a data signal at the data input based on a clock signal at the clock input, the clock signal from the first die, the clock signal to be source-synchronous with the data signal.

Example 10 includes the integrated circuit of example 9, wherein the clock signal is a first clock signal, the clock input is a first clock input of the FIFO, the FIFO has a second clock input and a data output, and the FIFO is to provide data at the data output of the FIFO based on a second clock signal at the second clock input of the FIFO, the second clock signal associated with the second die.

Example 11 includes the integrated circuit of any one of examples 1 to 10, wherein first die is associated with a first process technology and the second die is associated with a second process technology different from the first process technology.

Example 12 includes the integrated circuit of any one of examples 1 to 11, wherein the source-synchronous data interface is a first source-synchronous data interface, the second die includes third microbumps associated with a second source-synchronous data interface of the 3D die stack, a first one of the third microbumps in circuit with a clock output of the second die, a second one of the third microbumps in circuit with a data output of the second die, the clock output and the data output of the second die associated with a transmitter side of the second source-synchronous data interface, and the first die includes fourth microbumps associated with the second source-synchronous data interface of the 3D die stack, a first one of the fourth microbumps in circuit with a clock input of the first die, a second one of the fourth microbumps in circuit with a data input of the first die, the clock input and the data input of the first die associated with a receiver side of the second source-synchronous data interface, the first one of the third microbumps and the first one of the fourth microbumps bonded together and the second one of the third microbumps and the second one of the fourth microbumps bonded together.

Example 13 includes the integrated circuit of any one of examples 1 to 12, wherein the second die is above the first die in the 3D die stack.

Example 14 includes the integrated circuit of any one of examples 1 to 13, wherein the first die includes a third microbump in circuit with o the clock output, the third microbump separate from the first microbumps, and the second die includes test circuitry in circuit with the clock input and the data input of the second die, and a fourth microbump in circuit with test circuitry, the fourth microbump to be bonded with the third microbump when the first die and the second die are bonded together to provide a first clock signal at the clock output of the first die to the test circuitry of the second die, the test circuitry to select between the first clock signal and a second clock signal to test the receiver side of the source-synchronous data interface.

Example 15 includes a first semiconductor die comprising circuitry to implement a transmitter side of a source-synchronous data interface, the circuitry having a clock output and a plurality of data outputs, the circuitry to provide respective data signals at the data outputs that are synchronized with a clock signal at the clock output, and microbumps respectively in circuit with the clock output and the data outputs, the microbumps arranged such that a first one of the microbumps in circuit with the clock output is centrally located among the microbumps, the microbumps to bond with a second semiconductor die that implements a receiver side of the source-synchronous data interface.

Example 16 includes the first semiconductor die of example 15, wherein the circuitry includes first flip-flops clocked based on the clock signal to generate a first one of the data signals, the first one of the data signals to be a double data rate signal with data transitions synchronized with both rising edges and falling edges of the clock signal, and second flip-flops to delay the clock signal to synchronize the clock signal with the first one of the data signals.

Example 17 includes the first semiconductor die of example 15 or example 16, wherein the circuitry is first circuitry, the source-synchronous data interface is a first source-synchronous data interface, the data signals are first data signals, the clock signal is a first clock signal, the microbumps are first microbumps, and including second circuitry to implement a receiver side of a second source-synchronous data interface, the second circuitry having a clock input and a plurality of data inputs, the second circuitry to sample respective second data signals at the data inputs based a second clock signal at the clock input, and second microbumps respectively in circuit with the clock input and the data inputs of the second circuitry, the second microbumps different from the first microbumps, the second microbumps arranged such that a first one of the second microbumps in circuit with the clock input is centrally located among the second microbumps, the second microbumps to bond with the second semiconductor die, the second semiconductor die to implement a transmitter side of the second source-synchronous data interface.

Example 18 includes a first semiconductor die comprising circuitry to implement a receiver side of a source-synchronous data interface, the circuitry having a clock input and a plurality of data input, the circuitry to sample input data signals at the data inputs based on a clock signal at the clock input, and microbumps respectively in circuit with the clock input and the data inputs, the microbumps arranged such that a first one of the microbumps in circuit with the clock input is centrally located among the microbumps, the microbumps to bond with a second semiconductor die that implements a source side of the source-synchronous data interface.

Example 19 includes the first semiconductor die of example 18, wherein the input data signals are from the second semiconductor die, the clock input is a first clock input, the clock signal is a first clock signal from the second semiconductor die, the circuitry includes a second clock input and a plurality of data outputs, and the circuitry is to provide output data at the data outputs at time intervals corresponding to a second clock signal at the second clock input, the output data based on the sampled input data signals, the second clock signal associated with the first semiconductor die.

Example 20 includes the first semiconductor die of example 18 or example 19, wherein the circuitry is first circuitry, the source-synchronous data interface is a first source-synchronous data interface, the clock signal is a first clock signal, the microbumps are first microbumps, and including second circuitry to implement a transmitter side of a second source-synchronous data interface, the second circuitry having a clock output and a plurality of data outputs, the second circuitry to provide respective output data signals at the data outputs that are synchronized with a clock signal at the clock output, and second microbumps respectively in circuit with the clock output and the data outputs of the second circuitry, the second microbumps different from the first microbumps, the second microbumps arranged such that a first one of the second microbumps in circuit with the clock output is centrally located among the second microbumps, the second microbumps to bond with the second semiconductor die, the second semiconductor die to implement a receiver side of the second source-synchronous data interface.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An integrated circuit comprising:
a first die including first microbumps associated with a source-synchronous data interface of a three-dimensional, 3D, die stack, a first one of the first microbumps in circuit with a clock output of the first die, a second one of the first microbumps in circuit with a data output of the first die, the clock output and the data output associated with a transmitter side of the source-synchronous data interface; and
a second die including second microbumps associated with the source-synchronous data interface of the 3D die stack, a first one of the second microbumps in circuit with a clock input of the second die, a second one of the second microbumps in circuit with a data input of the second die, the clock input and the data input associated with a receiver side of the source-synchronous data interface, the first one of the first microbumps and the first one of the second microbumps bonded together and the second one of the first microbumps and the second one of the second microbumps bonded together.

2. The integrated circuit of claim 1, wherein the first microbumps are respectively in circuit with data outputs associated with the transmitter side of the source-synchronous data interface, the first microbumps are included in a region of the first die, the region defined by a perimeter defined by ones of the microbumps, and the first one of the first microbumps is an interior microbump relative to the perimeter.

3. The integrated circuit of claim 2, wherein the first one of the first microbumps is located centrally in the region of the first die.

4. The integrated circuit of any one of claims 1 to 3, wherein the first microbumps include cells of microbumps in a grid, a first one of the cells including the first one of the first microbumps and a first plurality of microbumps that at least partially surround the first one of the first microbumps, the first plurality of microbumps in circuit with a first plurality of data outputs associated with the transmitter side of the source-synchronous data interface, other ones of the cells including respective pluralities of microbumps in circuit with respective pluralities of data outputs associated with the transmitter side of the source-synchronous data interface.

5. The integrated circuit of claim 4, wherein the first one of the cells is centrally located in the grid.

6. The integrated circuit of any one of claims 1 to 5, wherein the first die includes:
a clock distribution circuit having the clock output; and
a router circuit to synchronize a data signal at the data output with a clock signal at the clock output, the clock distribution circuit and the router circuit to implement the transmitter side of the source-synchronous data interface.

7. The integrated circuit of claim 6, wherein the data signal is a double data rate signal, and the router circuit is to synchronize data transitions of the data signal with both rising edges and falling edges of the clock signal.

8. The integrated circuit of any one of claims 1 to 7, wherein the first die includes:
a first buffer circuit in communication with the first one of the first microbumps and the clock output of the first die; and
a second buffer circuit in communication with the second one of the first microbumps to the data output of the first die.

9. The integrated circuit of any one of claims 1 to 8, wherein the second die includes a first-in-first-out, FIFO, circuit having the clock input and the data input, the FIFO circuit to implement the receiver side of the source-synchronous data interface, the FIFO circuit to sample a data signal at the data input based on a clock signal at the clock input, the clock signal from the first die, the clock signal to be source-synchronous with the data signal.

10. The integrated circuit of claim 9, wherein the clock signal is a first clock signal, the clock input is a first clock input of the FIFO, the FIFO has a second clock input and a data output, and the FIFO is to provide data at the data output of the FIFO based on a second clock signal at the second clock input of the FIFO, the second clock signal associated with the second die.

11. The integrated circuit of any one of claims 1 to 10, wherein the first die is associated with a first process technology and the second die is associated with a second process technology different from the first process technology.

12. The integrated circuit of any one of claims 1 to 11, wherein:
the source-synchronous data interface is a first source-synchronous data interface;
the second die includes third microbumps associated with a second source-synchronous data interface of the 3D die stack, a first one of the third microbumps in circuit with a clock output of the second die, a second one of the third microbumps in circuit with a data output of the second die, the clock output and the data output of the second die associated with a transmitter side of the second source-synchronous data interface; and
the first die includes fourth microbumps associated with the second source-synchronous data interface of the 3D die stack, a first one of the fourth microbumps in circuit with a clock input of the first die, a second one of the fourth microbumps in circuit with a data input of the first die, the clock input and the data input of the first die associated with a receiver side of the second source-synchronous data interface, the first one of the third microbumps and the first one of the fourth microbumps bonded together and the second one of the third microbumps and the second one of the fourth microbumps bonded together.

13. The integrated circuit of any one of claims 1 to 12, wherein the second die is above the first die in the 3D die stack.

14. The integrated circuit of any one of claims 1 to 13, wherein:
the first die includes a third microbump in circuit with the clock output, the third microbump separate from the first microbumps; and
the second die includes:
test circuitry in circuit with the clock input and the data input of the second die; and
a fourth microbump in circuit with test circuitry, the fourth microbump to be bonded with the third microbump when the first die and the second die are bonded together to provide a first clock signal at the clock output of the first die to the test circuitry of the second die, the test circuitry to select between the first clock signal and a second clock signal to test the receiver side of the source-synchronous data interface.
